# EUROPEAN PATENT SPECIFICATION

(11) **EP 3 919 970 B1**
(45) Date of publication and mention of the grant of the patent: **20.08.2025**
(21) Application number: 19912701.0
(22) Date of filing: 02.02.2019
(51) Int. Cl.: G02F 1/13, H01L 21/66, H01L 25/075

(54) **LED FLIP-CHIP DISPLAY SCREEN AND MANUFACTURING METHOD THEREFOR**
LED-FLIP-CHIP-ANZEIGESCHIRM UND HERSTELLUNGSVERFAHREN DAFÜR
ÉCRAN D'AFFICHAGE À DEL À PUCE RETOURNÉE ET SON PROCÉDÉ DE FABRICATION

(43) Date of publication of application: 08.12.2021
(73) Proprietor: Xiamen San'an Optoelectronics Co., Ltd., Fujian Province 361100 (CN)
(72) Inventor: WU, Ji-Pu, Xiamen, Fujian 361100 (CN); LIN, Tsung-Ming, Xiamen, Fujian 361100 (CN); TENG, Yu-Tsai, Xiamen, Fujian 361100 (CN); TSENG, Ho-Chia, Xiamen, Fujian 361009 (CN)
(74) Representative: Bals & Vogel Patentanwälte PartGmbB
(86) International application number: PCT/CN2019/074639
(87) International publication number: WO 2020/155162

(56) References cited:
- WO-A1-2019/008262
- CN-A- 102 128 423
- CN-A- 102 856 474
- CN-A- 104 640 312
- CN-A- 105 929 574
- CN-A- 109 103 119
- KR-B1- 100 880 812
- US-B1- 8 348 749

## Description

### TECHNICAL FIELD

The present invention relates to a technical field of LED chip sorting machine and LED display screen, and more particularly to a flip-chip LED display screen and a manufacturing method therefor.

### BACKGROUND

In a field of an LED display screen, users hope to obtain a clear display effect, and gradually pay more attention to a consistency of an overall screen effect. In a stage of point testing and sorting when preparing a chip, according to a sorting/arranging logic for the chip in the prior art, the chips with a same bin specification will be arranged in sequence. When a packaging manufacturer packages the chips mentioned above in sequence and then assembles a screen subsequently, a problem of chromaticity difference in the display effect of a whole screen has gradually appeared, and a brightness difference and a color difference between screens will appear. Therefore, how to eliminate the brightness difference and the color difference among the screens has become a key issue in an entire field of LED display screen manufacturing.

In order to solve brightness and color problems among the screens mentioned above, in a field of surface mounted device (SMD) packaging, a phenomenon of color difference is eliminated mainly by a three-time mixing for the chips: (1) mixing blue films of different batches; (2) mixing lamp beads after SMD packaging; (3) mixing an SMD braid. In SMD packaging, a problem of color difference among modules is eliminated through the three-time mixing. However, since three stages of process are required, and at the same time, in a first stage of mixing the blue films of different batches, a part of a previous batch of blue films need to be retained in each time of blue film mixing, problems such as low production efficiency, uneven chip mixing, and incomplete mixing exist. In a field of chip-on-board (COB) packaging, in order to solve a chromaticity difference problem in the modules, a current mainstream solution of various packaging manufacturers is to perform chromaticity correction on the whole screen. However, due to the cost of correction equipment, the imperfection of correction technology, and differences in packaged products, the chromaticity difference problem in the modules cannot be fundamentally solved.

WO 2019/008262 A1 discloses a display device (100), comprising: a support; first and second conductive electrical power supply elements (106, 108), the first conductive element being placed on the support; a plurality of LED modules (104), each including at least one LED and two electrical power supply pads that are arranged on two opposite faces, respectively, of the LED module, one of which corresponds to an emissive face of the LED, wherein the electrical power supply pads of each LED module are connected to the first and second conductive electrical power supply elements, respectively, and wherein the connection area of an electrical power supply pad of an LED module for connection with the first conductive electrical power supply element is substantially smaller than a receiving area of the first conductive element corresponding to the area of the first conductive element in a plane that is parallel to the connection areas of the power supply pads of the LED modules.

KR 100880812 B1 discloses a method of making a light active sheet. A bottom substrate having an electrically conductive surface is provided. A hotmelt adhesive sheet is provided. Light active semiconductor elements, such as LED die, are embedded in the hotmelt adhesive sheet. The LED die each have a top electrode and a bottom electrode. A top transparent substrate is provided having a transparent conductive layer. The hotmelt adhesive sheet with the embedded LED die is inserted between the electrically conductive surface and the transparent conductive layer to form a lamination. The lamination is run through a heated pressure roller system to melt the hotmelt adhesive sheet and electrically insulate and bind the top substrate to the bottom substrate. As the hotmelt sheet is softened, the LED die breakthrough so that the top electrode comes into electrical contact with the transparent conductive layer of the top substrate and the bottom electrode comes into electrical contact with the electrically conductive surface of the bottom substrate. Thus, the p and n sides of each LED die are automatically connected to the top conductive layer and the bottom conductive surface. Each LED die is encapsulated and secured between the substrates in the flexible, hotmelt adhesive sheet layer. The bottom substrate, the hotmelt adhesive (with the embedded LED die) and the top substrate can be provided as rolls of material. The rolls are brought together in a continuous roll fabrication process, resulting in a flexible sheet of lighting material.

CN 102128423 A discloses a light emitting diode (LED) module-based random matrix lamp mixing method and a system device thereof. The device comprises an artificial intelligence (AI) inserter. The method comprises the following steps of: constructing a software module for generating a random matrix, an AI inserter control end software module and an AI inserter functional module in an AI inserter control end PC according to LED module pixels; after real-time start, generating the random matrix according to the batch and the number of LED lamps; calling the random matrix and building a corresponding relationship between the feeding station number and the LED module pixels by the AI inserter control end software module; building a corresponding relationship between the LED batch and the feeding station number by the AI inserter functional module; and controlling the AI inserter to take out each LED lamp from the corresponding feeding station by the AI inserter control end software module, and inserting the LED lamps into corresponding positions of the modules to realize lamp mixing. By adopting computer programming for generating the random matrix, the risk of regular patterns of LED modules is reduced; and the same random matrix is adopted in each LED module, so the LED batch and the pixel positions of LEDs on the LED modules are fixed, the traceability of the LED lamps is realized, and the production risk is effectively controlled.

### SUMMARY

In view of the defects in the prior art mentioned above, an objective of the present invention is to provide a manufacturing method for an LED display screen for resolving differences in brightness and color among screens more conveniently and reliably.

In order to achieve the above objective and other related objectives, the present invention provides a manufacturing method for an LED display screen, including: preparing a batch of LED chips of the same or different specification; picking up the LED chips illogically according to a random sampling method, and arranging the picked LED chips in sequence; packaging and assembling the LED chips arranged in sequence to form the LED display screen. The LED display screen comprises an area comprising a plurality of LED chips, and not all adjacent LED chips in a certain area of the LED display screen are adjacent LED chips of the same specification, the specification of the LED chip comprising a specification of at least one of color and brightness.

### BRIEF DESCRIPTION OF THE DRAWINGS

FIG. 1 is a schematic diagram showing an arrangement of LED chips after sorting/arraying in the prior art.
FIG. 2 is a schematic flowchart showing a manufacturing method for an LED package device provided in a first embodiment.
FIG. 3 is a schematic diagram showing a structure of LED chips classified in different Bins according to the method shown in FIG. 2.
FIG. 4 is a schematic diagram showing a structure of the sorted LED chips after being performed a random arrangement according to the method shown in FIG. 2.
FIG. 5 is a schematic diagram showing a picking up process of a random arrangement for LED chips.
FIG. 6 is a schematic diagram showing an arrangement of the picked LED chips.

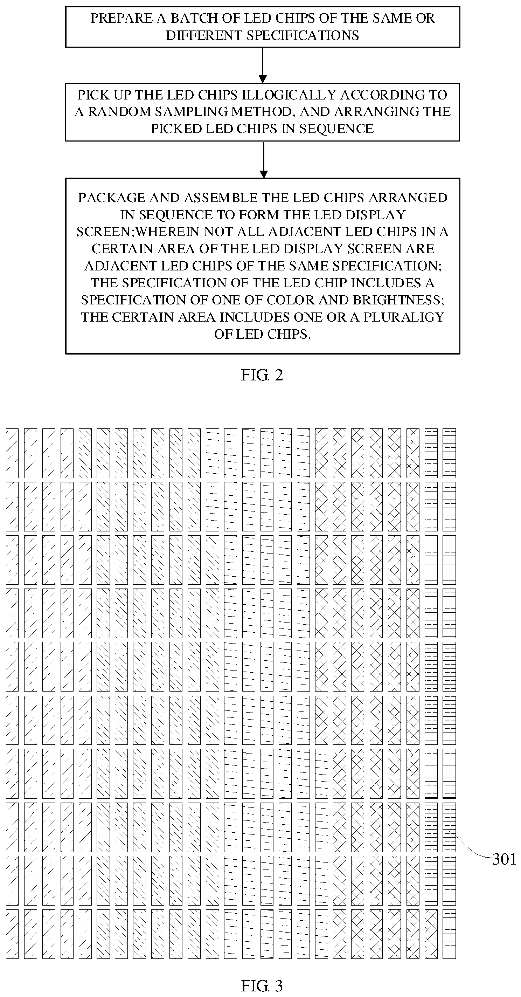

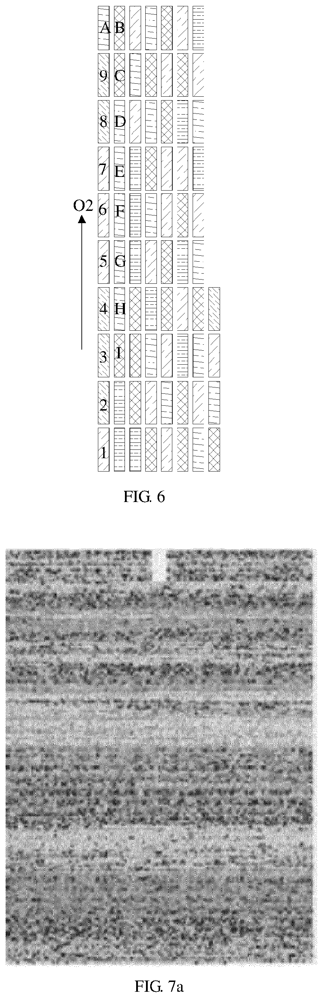

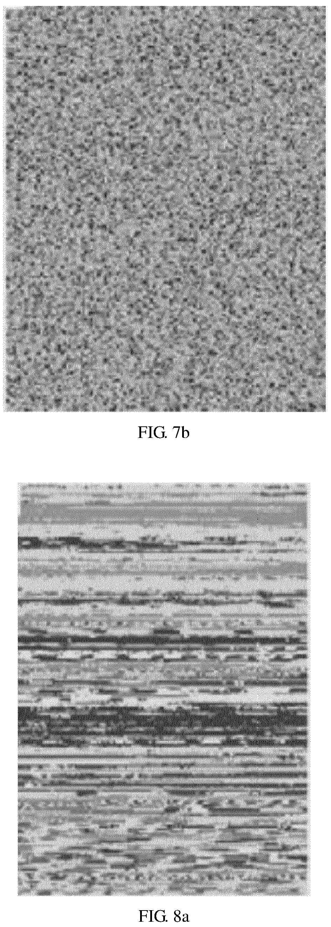

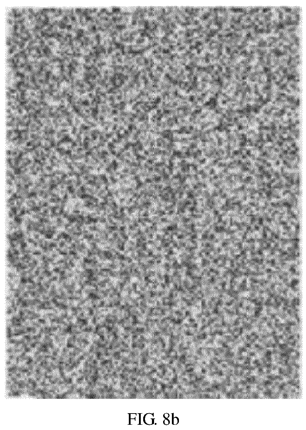

FIGS. 7a-8b are schematic diagrams showing a display effect according to a prior art sorting method and a display effect of a flip-chip LED display screen formed by packaging the randomly arranged LED chips according to the method shown in FIG. 2; FIG. 7a is a schematic diagram showing a display effect of a flip-chip LED display screen with a brightness step of 0.5 mW according to the prior art; FIG. 7b is a schematic diagram showing a display effect of a flip-chip LED display screen with a brightness step of 0.5 mW formed by the method shown in FIG. 2; FIG. 8a shows a schematic diagram showing a display effect of a flip-chip LED display screen with a wavelength step of 0.5 nm according to the prior art; FIG. 8b is a schematic diagram showing a display effect of a flip-chip LED display screen with a wavelength step of 0.5 nm formed by the method shown in FIG. 2.

### Description of Reference Numerals:

10, Display Module; 101, LED Chip; 30, Display Module; 301, LED Chip.

### DETAILED DESCRIPTION OF THE EMBODIMENTS

An embodiment of the present invention will be described below through an exemplary embodiment. Those skilled in the art can easily understand other advantage and effect of the present invention according to content disclosed in the Description. The present invention can also be implemented or applied through other different exemplary embodiment. Various modifications or changes can also be made to all details in the Description based on different points of view and applications without departing from a scope of the present invention.

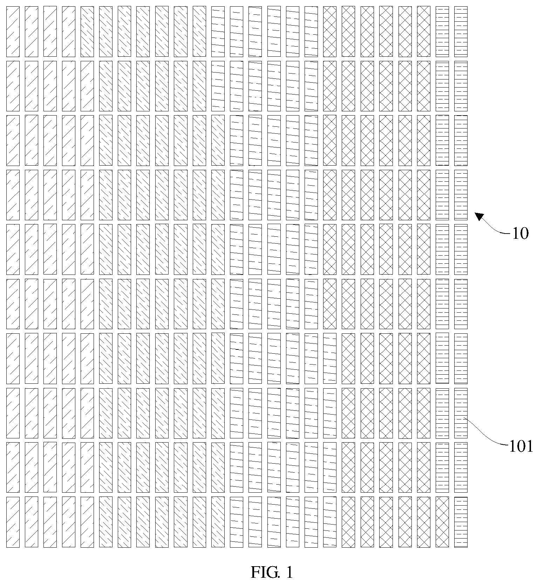

In an LED display screen manufacturing process, sorting LED chips is a very important step. A sorting/arraying technology in the prior art usually arranges the LED chips logically, and the LED chips 101 of the same bin specification are arranged sequentially to form a display module 10, as shown in FIG. 1. According to the above sorting/arraying, after the display module 10 is assembled into an LED screen after subsequent packaging, a brightness difference and a color difference will appear between screens, and a striped or blocky color difference/brightness difference will appear, as shown in FIGS. 7a and 8a.

### EMBODIMENT 1

In order to solve a problem of brightness difference and color difference among screens caused by LED sorting in the prior art, a manufacturing method for a flip-chip LED display screen is provided in the present embodiment, as shown in FIGS. 2-6, including the following steps.

A batch of LED chips of the same or different specifications is prepared.

The above-mentioned LED chips of the same or different specifications can be from a same wafer or from different wafers. In an embodiment, as shown in FIG. 3, it shows that LED chips 301 of the same specification from different wafers are classified into different bins. In an embodiment, the LED chips can also be classified into a same bin but with different brightness or wavelengths. In the present embodiment, the specifications of the LED chips 301 include the specification of at least one of color and brightness.

The LED chips are picked up illogically according to a random sampling method, and the picked LED chips are arranged on a substrate.

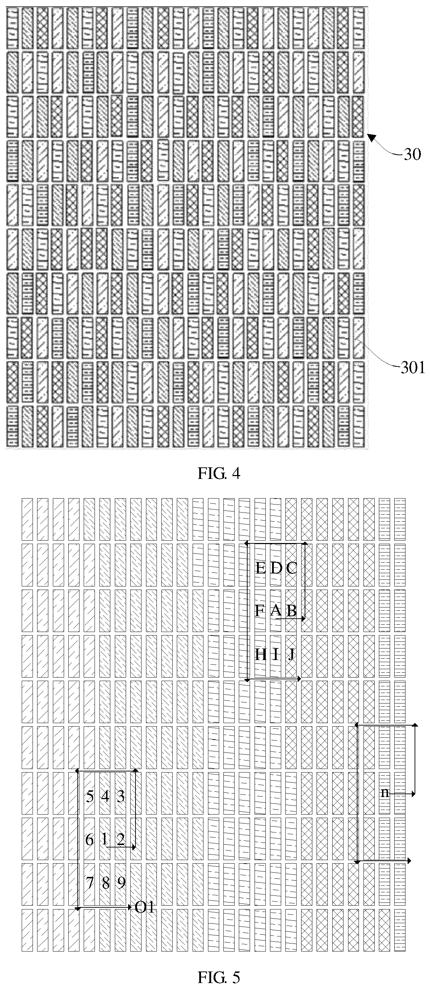

As shown in FIG. 4, a display module 30 presented after the LED chips being picked up illogically and arranged is shown. It can be seen from FIG. 4 that the LED chips 301 in the display module 30 formed after the picking up and the arranging mentioned above are distributed in the display module 30 in a scattered and even manner.

The LED chips arranged on the substrate are packaged and transferred to a circuit substrate, and are assembled to form the LED display screen. The packaged LED chips can be transferred one by one sequentially to the circuit substrate or a plurality of the packaged LED chips can be transferred in a batch to the circuit substrate.

After the display module 30 as shown in FIG. 4 forms an LED display, not all the adjacent LED chips in a certain area of the LED display screen are adjacent LED chips of the same specification, and the certain area includes one LED chip or more. The certain area may be, for example, consisted of 3 × 4 LED chips, 6 × 8 LED chips, 2 × 5 LED chips, or the like. There will be no striped or blocky color difference and brightness difference phenomena between screens. As shown in FIGS. 7b and 8b, no matter the bins are classified according to a same brightness and different wavelengths (colors) or are classified according to a same wavelength and different brightness, after the picking up illogically and the arranging mentioned above, the LED chips 301 are distributed in each display module 30 in a scattered and even manner. Therefore, after the display module 30 is assembled into a display screen, there will be no striped or blocky color difference/brightness difference between screens.

In an embodiment, as shown in FIGS. 5 and 6, a process of picking up and arranging the LED chips of the same specification from different wafers is shown.

As shown in FIG. 5, firstly, the LED chips of the same specification from different wafers are placed on one or more carrier films sequentially. The carrier film can be any adhesive carrier film such as blue film, white film, PVC film, or the like. Then, the LED chips mentioned above are picked up illogically according to the random sampling method. In an embodiment, the random sampling method includes a random number table method, and a random number table in the random number table method includes one of a Fisher-Yates random number table, a Tippet random number table, and a Kendell-Smith random number table. In the present embodiment, the random number table method is used to pick up the above-mentioned LED chips illogically. Firstly, the first picking point is randomly selected, and the LED chip 1 at the first picking point is picked up, or the LED chip 1 at the first picking point is picked up and at the same time the LED chips around the first picking point are sequentially picked up along a predetermined picking direction O1. For example, a first number of LED chips ranging from one to eight around the first picking point can be picked up. In the present embodiment, eight LED chips 2-9 around the first picking point are picked up. The picking direction O1 may be a counterclockwise direction or a clockwise direction. In an embodiment, as shown in FIG. 5, the picking direction O1 is a counterclockwise direction.

The LED chip 1 at the first picking point and the LED chips 2-9 around it are arranged on the substrate in sequence in a predetermined arrangement manner. The predetermined arrangement manner can be determined according to a final product requirement of the LED display screen. For example, as shown in FIG. 6, the predetermined arrangement manner includes a vertical turn-back arrangement manner O2, and of course, it may also be a horizontal turn-back arrangement manner.

After picking up and arranging the LED chips at the first picking point, randomly jump to a second picking point and the LED chip A at the second picking point is picked up, or the LED chip A at the second picking point is picked up and at the same time a second number of the LED chips around the second picking point are sequentially picked up along the predetermined picking direction O1. For example, eight LED chips B-I around the second picking point are also picked up. Then, the LED chip A at the second picking point and the LED chips B-I around it are arranged on the substrate in sequence in a predetermined arrangement manner.

Jump to an n-th picking point randomly, and the LED chip at the n-th picking point and an n-th number of LED chips around the n-th picking point are picked up along the predetermined picking direction.

The LED chip and the n-th number of LED chips picked at the n-th picking point are arranged on the substrate in sequence according to the predetermined arrangement manner.

The above-mentioned steps of picking up and arranging randomly are repeated until all the LED chips are picked up and arranged, and a required arrangement pattern is formed. The arrangement pattern can also be determined according to the final product requirement of the LED display screen.

As shown in FIGS. 5 and 6, the first picking point, the second picking point, ... and the n-th picking point include illogical points that are randomly selected by the random sampling method; the first number of LED chips, the second number of LED chips, ... and the n-th number of LED chips include 0 to 8 LED chips. Further, n is an integer greater than 2.

Then, the LED chips placed on the substrate are packaged and transferred onto the circuit substrate to form the display module shown in FIG. 4, and the display module is assembled to form the LED display screen.

As shown in FIG. 4, the LED chips in each display module are distributed in a scattered and even manner. Thus, after the LED display screen is formed, the striped or blocky color difference/brightness difference will not appear between screens.

In order to obtain a more scattered and even distribution of LED chips, and as far as possible to completely eliminate the striped or blocky color difference/brightness difference that may appear between screens, the steps of picking up illogically and arranging sequentially can be repeated many times, until reaching a desired display effect.

### EMBODIMENT 2

The present embodiment provides a manufacturing method for the flip-chip LED display screen. Same parts as those in the first embodiment will not be repeated here, and a difference is as follows.

In the present embodiment, the LED chips can be picked up directly from a wafer from which the LED chips are cut out illogically according to the random sampling method; then the picked LED chips are arranged on the carrier film, which can also be any adhesive carrier film such as a blue film, a white film and a PVC film; then the LED chips on the carrier film are transferred onto the circuit substrate in a batch; and the LED chips transferred onto the circuit substrate are packaged and assembled to form the LED display screen.

According to the method shown in the above embodiment of the present invention, the LED chips of the same or different specifications from the same wafer can be picked up illogically directly and then be arranged. Therefore, the method can directly pick up the LED chips without classifying the bin of the LED chips, and realize a scattered and even distribution of the LED chips. In addition, according to this method, the LED chips of different bins of the same specification from different wafers can also be picked up illogically and arranged. That is, the scattered and even distribution of the LED chips of different bins is realized. The above method enables the LED chips to be distributed in a scattered and even manner in a final LED screen, without causing striped or blocky color difference/brightness difference between screens.

In addition, the above method can realize the scattered and even distribution of the LED chips by performing the picking up illogically only once, and thus a realization process is simple, and a sorting cost is low.

In another embodiment, the LED chips mentioned above include a flip-chip Mini LED chip or a flip-chip Micro LED chip.

### EMBODIMENT 3

An LED display screen is provided in the present embodiment. The LED display screen includes a display unit, and the display unit includes a circuit substrate and LED chips soldered on the circuit substrate.

The LED chips includes LED chips from a same wafer and/or LED chips from different wafers. The LED chips are arranged randomly and then soldered on the circuit substrate. Adjacent LED chips include no adjacent LED chips of the same specification. The specification of the LED chip includes at least one of color and brightness of the LED chip.

In an embodiment, the LED chip includes a flip-chip Mini LED chip or Micro LED chip.

In another embodiment, the LED display screen further includes a control system which is electrically connected with the display unit to control the display unit to display based on a different requirement.

According to the LED display screen of the present embodiment, the LED chips are arranged according to the method described in the first embodiment, so that the LED chips are distributed in a scattered and even manner in the LED display screen. Therefore, the LED display screen does not need to rely on a control of a system drive circuit to distribute current to make the brightness and color of the screen uniform, and there is no need to use Pulse Width Modulation (PWM) to adjust a duty cycle to achieve uniform brightness. The LED display screen has a function of independently turning on an R/G/B three-color light. A same drive current is used to turn on R/G/B, and the striped or blocky color difference/brightness difference will not appear in the LED display screen.

As mentioned above, the LED display screen and the manufacturing method therefor of the present invention provide the following beneficial effects.

According to the method of embodiments of the present invention, the chips in a single specification or a plurality of specifications are picked up illogically and arranged for one time or more. The chips picked up and arranged according to the above-mentioned method will not show differences in brightness and color after packaging and assembling the chips to form the screen subsequently. In addition, the method of the present invention can be realized by incorporating a random number table method into operation of an existing device, and a realization process is simple. There is no need to change or design the device or a manufacturing process, and an operating cost is low and the method is easy to realize.

According to this method, the LED chips of the same or different specifications from the same wafer can be picked up illogically directly and then be arranged. Therefore, the method can directly pick up the LED chips without classifying the bin of the LED chips, and realize a scattered and even distribution of the LED chips. In addition, according to this method, the LED chips of different bins of the same specification from different wafers can also be picked up illogically and arranged. That is, the scattered and even distribution of the LED chips of different bins is realized. The above method enables the LED chips to be distributed in a scattered and even manner in a final LED screen, without causing striped or blocky color difference/brightness difference between screens.

In addition, according to the method of embodiments of the present invention, the chips on a source side are randomly arranged, and the chips on the source side are randomly arranged on a product, which is easy to realize a mass production. In addition, since the chips within a package module or within the screen are arranged randomly, there is no striped or blocky color difference/brightness difference. When the module and the module or the screen and the screen are further assembled, a striped or blocky color difference/brightness difference phenomenon will not appear.

The above-mentioned embodiments are merely illustrative of a principle and an effect of the present invention instead of limiting the present invention. Those skilled in the art can make modifications or changes to the above-mentioned embodiments without going against the range of the present invention. Therefore, all equivalent modifications or changes made by those skilled in the art without departing from the scope of the present invention will be covered by the appended claims.

## Claims

1. A manufacturing method for an LED display screen, comprising:
preparing a batch of LED chips (301) of the same or different specifications;
picking up the LED chips (301) illogically according to a random sampling method, and arranging the picked LED chips (301) in sequence; and
packaging and assembling the LED chips (301) arranged in sequence to form the LED display screen;
wherein the LED display screen comprises an area comprising a plurality of LED chips (301), and not all adjacent LED chips (301) in an area of the LED display screen are adjacent LED chips (301) of the same specification, the specification of the LED chip (301) comprising a specification of at least one of color and brightness.

2. The manufacturing method of claim 1, wherein the picking up the LED chips (301) illogically according to the random sampling method, and arranging the picked LED chips (301) in sequence comprises:
performing n times of a picking-arranging process, the picking-arranging process comprising selecting a picking point randomly and picking up the LED chip (301) at the picking point and a number of LED chips (301) around the picking point along a predetermined picking direction (O1), and arranging the picked LED chip (301) at the picking point and the number of LED chips (301) in sequence according to a predetermined arrangement manner (O2);
wherein n is an integer greater than 2;
wherein a first picking point is selected and a first number of LED chips (301) around the first picking point are picked when performing the first time of the picking-arranging process; a second picking point is selected and a second number of LED chips (301) around the second picking point are picked when performing the second time of the picking-arranging process; and a n-th picking point is selected and a n-th number of LED chips (301) around the n-th picking point are picked when performing the n-th time of the picking-arranging process; and
wherein the LED chip (301) at the n-th picking point and the n-th number of LED chips (301), the LED chip (301) at the second picking point and the second number of LED chips (301), and the LED chip (301) at the first picking point and the first number of LED chips (301) are continuously arranged.

3. The manufacturing method of claim 2, wherein the predetermined picking direction (O1) comprises a counterclockwise direction or a clockwise direction, and the predetermined arrangement manner (O2) and the arrangement pattern are determined by a requirement of the LED display screen.

4. The manufacturing method of claim 2, wherein
the first picking point, the second picking point, and the n-th picking point comprise illogical points that are randomly selected by the random sampling method; and
the first number of LED chips (301), the second number of LED chips (301), and the n-th number of LED chips (301) comprise 0 to 8 LED chips (301).

5. The manufacturing method of claim 1, wherein the batch of LED chips (301) of the same or different specifications is from a wafer in a single specification or wafers in a plurality of specifications; and the LED chips (301) comprises a flip-chip Mini LED or Micro LED chip.

6. The manufacturing method of claim 1, wherein the random sampling method comprises a random number table method, wherein a random number table comprises one of a Fisher-Yates random number table, a Tippet random number table, and a Kendell-Smith random number table.

7. The manufacturing method of claim 1, wherein the preparing the batch of LED chips (301) of the same or different specifications comprises placing the LED chips (301) of the same specification from different wafers sequentially on a plurality of carrier films.

8. The manufacturing method of claim 1, wherein the picking up the LED chips (301) illogically according to the random sampling method, and arranging the picked LED chips (301) in sequence comprises arranging the picked LED chips (301) on a substrate in sequence;
wherein the packaging and assembling the LED chips (301) arranged in sequence to form the LED display screen comprises:
packaging the LED chips (301) arranged on the substrate; and
transferring the packaged LED chips (301) onto a circuit substrate and assembling the same to form the LED display screen; and
wherein the transferring the packaged LED chips (301) onto the circuit substrate comprises transferring the packaged LED chips (301) one by one sequentially or transferring a plurality of the packaged LED chips (301) in a batch.

9. The manufacturing method of claim 1, wherein the picking up the LED chips (301) illogically according to a random sampling method, and arranging the picked LED chips (301) in sequence further comprises:
picking up the LED chips (301) directly from a wafer from which the LED chips (301) are cut out illogically according to the random sampling method; and
arranging the picked LED chips (301) on a carrier film.

10. The manufacturing method of claim 9, wherein the packaging and assembling the LED chips (301) arranged in sequence to form the LED display screen comprises:
transferring the LED chips (301) arranged on the carrier film onto a circuit substrate in a batch; and
packaging and assembling the LED chips (301) transferred onto the circuit substrate to form the LED display screen.

11. The manufacturing method of claim 2, wherein the predetermined picking direction (O1) is formulated to pass at least two adjacent bins which having different specifications of brightness and/or color of the LED chips (301).

12. The manufacturing method of claim 11, wherein the predetermined picking direction (O1) is not same as the predetermined arrangement manner (O2).

## Patentansprüche

1. Herstellungsverfahren für einen LED-Anzeigeschirm, umfassend:
Vorbereiten einer Charge von LED-Chips (301) mit denselben oder unterschiedlichen Spezifikationen;
unlogisches Aufnehmen der LED-Chips (301) gemäß einem Zufallsauswahlverfahren und Anordnen der aufgenommenen LED-Chips (301) in einer Reihenfolge; und
Verpacken und Zusammenbau der LED-Chips (301), die nacheinander angeordnet sind, um den LED-Bildschirm zu bilden;
wobei der LED-Anzeigeschirm einen Bereich umfasst, der eine Vielzahl von LED-Chips (301) umfasst, und nicht alle benachbarten LED-Chips (301) in einem Bereich des LED-Anzeigeschirms benachbarte LED-Chips (301) mit der gleichen Spezifikation sind, wobei die Spezifikation des LED-Chips (301) eine Spezifikation von mindestens einem von Farbe und Helligkeit umfasst.

2. Herstellungsverfahren nach Anspruch 1, wobei das unlogische Aufnehmen der LED-Chips (301) gemäß dem Zufallsauswahlverfahren und das Anordnen der aufgenommenen LED-Chips (301) in Reihenfolge umfasst:
n-maliges Durchführen eines Entnahme-Anordnungsprozesses, wobei der Entnahme-Anordnungsprozess das zufällige Auswählen eines Entnahmepunktes und das Aufnehmen des LED-Chips (301) an dem Entnahmepunkt und einer Anzahl von LED-Chips (301) um den Entnahmepunkt herum entlang einer vorbestimmten Entnahmerichtung (O1) und das Anordnen des aufgenommenen LED-Chips (301) an dem Entnahmepunkt und der Anzahl von LED-Chips (301) in einer Reihenfolge gemäß einer vorbestimmten Anordnungsart (O2) umfasst;
wobei n eine ganze Zahl größer als 2 ist;
wobei ein erster Entnahmepunkt ausgewählt wird und eine erste Anzahl von LED-Chips (301) um den ersten Entnahmepunkt herum entnommen wird, wenn die erste Zeit des Entnahme-Anordnungsprozesses durchgeführt wird; ein zweiter Entnahmepunkt ausgewählt wird und eine zweite Anzahl von LED-Chips (301) um den zweiten Entnahmepunkt herum entnommen wird, wenn die zweite Zeit des Entnahme-Anordnungsprozesses durchgeführt wird; und ein n-ter Entnahmepunkt ausgewählt wird und eine n-te Anzahl von LED-Chips (301) um den n-ten Entnahmepunkt herum entnommen wird, wenn die n-te Zeit des Entnahme-Anordnungsprozesses durchgeführt wird; und
wobei der LED-Chip (301) am n-ten Entnahmepunkt und die n-te Anzahl von LED-Chips (301), der LED-Chip (301) am zweiten Entnahmepunkt und die zweite Anzahl von LED-Chips (301), und der LED-Chip (301) am ersten Entnahmepunkt und die erste Anzahl von LED-Chips (301) kontinuierlich angeordnet sind.

3. Herstellungsverfahren nach Anspruch 2, wobei die vorbestimmte Aufnahmerichtung (O1) eine Richtung gegen den Uhrzeigersinn oder eine Richtung im Uhrzeigersinn umfasst, und die vorbestimmte Anordnungsart (O2) und das Anordnungsmuster durch eine Anforderung des LED-Anzeigeschirms bestimmt werden.

4. Herstellungsverfahren nach Anspruch 2, wobei
der erste Entnahmepunkt, der zweite Entnahmepunkt und der n-te Entnahmepunkt unlogische Punkte umfassen, die durch das Zufallsauswahlverfahren zufällig ausgewählt werden; und
die erste Anzahl von LED-Chips (301), die zweite Anzahl von LED-Chips (301) und die n-te Anzahl von LED-Chips (301) 0 bis 8 LED-Chips (301) umfassen.

5. Herstellungsverfahren nach Anspruch 1, wobei die Charge von LED-Chips (301) mit denselben oder unterschiedlichen Spezifikationen von einem Wafer mit einer einzigen Spezifikation oder von Wafern mit mehreren Spezifikationen stammt und die LED-Chips (301) einen Flip-Chip-Mini-LED- oder Micro-LED-Chip umfassen.

6. Herstellungsverfahren nach Anspruch 1, wobei das Zufallsauswahlverfahren ein Zufallszahlentabellenverfahren umfasst, wobei eine Zufallszahlentabelle eine Fisher-Yates-Zufallszahlentabelle, eine Tippet-Zufallszahlentabelle oder eine Kendell-Smith-Zufallszahlentabelle umfasst.

7. Herstellungsverfahren nach Anspruch 1, wobei das Herstellen der Charge von LED-Chips (301) mit den gleichen oder unterschiedlichen Spezifikationen das aufeinanderfolgende Anordnen der LED-Chips (301) mit den gleichen Spezifikationen von unterschiedlichen Wafern auf einer Vielzahl von Trägerfolien umfasst.

8. Herstellungsverfahren nach Anspruch 1, wobei das unlogische Aufnehmen der LED-Chips (301) gemäß dem Zufallsauswahlverfahren und das Anordnen der aufgenommenen LED-Chips (301) in Folge das Anordnen der aufgenommenen LED-Chips (301) auf einem Substrat in Folge umfasst;
wobei das Verpacken und Zusammenbauen der LED-Chips (301), die nacheinander angeordnet sind, um den LED-Anzeigeschirm zu bilden, umfasst:
Verpacken der auf dem Substrat angeordneten LED-Chips (301); und
Übertragen der verpackten LED-Chips (301) auf ein Schaltungssubstrat und Zusammenbauen derselben, um den LED-Anzeigeschirm zu bilden; und
wobei das Übertragen der verpackten LED-Chips (301) auf das Schaltungssubstrat das Übertragen der verpackten LED-Chips (301) einzeln nacheinander oder das Übertragen einer Vielzahl der verpackten LED-Chips (301) in einer Charge umfasst.

9. Herstellungsverfahren nach Anspruch 1, wobei das unlogische Aufnehmen der LED-Chips (301) nach einem Zufallsauswahlverfahren und das Anordnen der aufgenommenen LED-Chips (301) in einer Reihenfolge umfasst:
Aufnehmen der LED-Chips (301) direkt von einem Wafer, aus dem die LED-Chips (301) gemäß dem Zufallsauswahlverfahren unlogisch ausgeschnitten sind; und
Anordnen der entnommenen LED-Chips (301) auf einer Trägerfolie.

10. Herstellungsverfahren nach Anspruch 9, wobei das Verpacken und Zusammenbauen der LED-Chips (301), die in Folge angeordnet sind, um den LED-Anzeigeschirm zu bilden, umfasst:
Übertragen der auf dem Trägerfilm angeordneten LED-Chips (301) auf ein Schaltungssubstrat in einer Charge; und
Verpacken und Zusammenbauen der auf das Schaltungssubstrat übertragenen LED-Chips (301) zur Bildung des LED-Anzeigeschirms.

11. Herstellungsverfahren nach Anspruch 2, wobei die vorbestimmte Entnahmerichtung (O1) so formuliert ist, dass sie an mindestens zwei benachbarten Bins vorbeiführt, die unterschiedliche Spezifikationen für die Helligkeit und/oder Farbe der LED-Chips (301) aufweisen.

12. Herstellungsverfahren nach Anspruch 11, wobei die vorgegebene Entnahmerichtung (O1) nicht mit der vorgegebenen Anordnungsart (O2) übereinstimmt.

## Revendications

1. Méthode de fabrication d'un écran d'affichage à LED, comprenant :
préparer un lot de puces LED (301) de spécifications identiques ou différentes ;
prélever les puces LED (301) de manière illogique selon une méthode d'échantillonnage aléatoire, et disposer les puces LED prélevées (301) dans l'ordre ; et
emballer et assembler les puces LED (301) disposées en séquence pour former l'écran d'affichage LED ;
dans lequel l'écran d'affichage LED comprend une zone comprenant une pluralité de puces LED (301), et toutes les puces LED adjacentes (301) dans une zone de l'écran d'affichage LED ne sont pas des puces LED adjacentes (301) de la même spécification, la spécification de la puce LED (301) comprenant une spécification d'au moins l'une des couleurs et de la luminosité.

2. Méthode de fabrication de la revendication 1, dans lequel le prélèvement des puces LED (301) de manière illogique selon la méthode d'échantillonnage aléatoire, et l'arrangement des puces LED prélevées (301) en séquence comprennent :
effectuer n fois un processus de préparation de commandes, le processus de préparation de commandes comprenant la sélection aléatoire d'un point de préparation et la préparation de la puce LED (301) au point de préparation et d'un certain nombre de puces LED (301) autour du point de préparation le long d'une direction de préparation prédéterminée (O1), et la disposition de la puce LED (301) préparée au point de préparation et du nombre de puces LED (301) en séquence conformément à une manière de disposition prédéterminée (O2) ;
où n est un nombre entier supérieur à 2 ;
dans lequel un premier point de prélèvement est sélectionné et un premier nombre de puces LED (301) autour du premier point de prélèvement est prélevé lors de l'exécution du premier temps du processus de prélèvement ; un deuxième point de prélèvement est sélectionné et un deuxième nombre de puces LED (301) autour du deuxième point de prélèvement est prélevé lors de l'exécution du deuxième temps du processus de prélèvement ; et un n-ième point de prélèvement est sélectionné et un n-ième nombre de puces LED (301) autour du n-ième point de prélèvement est prélevé lors de l'exécution du n-ième temps du processus de prélèvement ; et
dans lequel la puce LED (301) au n-ième point de prélèvement et le n-ième nombre de puces LED (301), la puce LED (301) au deuxième point de prélèvement et le deuxième nombre de puces LED (301), et la puce LED (301) au premier point de prélèvement et le premier nombre de puces LED (301) sont disposés en continu.

3. Méthode de fabrication de la revendication 2, dans laquelle la direction de prélèvement prédéterminée (O1) comprend une direction dans le sens inverse des aiguilles d'une montre ou une direction dans le sens des aiguilles d'une montre, et la manière de disposition prédéterminée (O2) et le modèle de disposition sont déterminés par une exigence de l'écran d'affichage à DEL.

4. Méthode de fabrication de la revendication 2, dans laquelle
le premier point de prélèvement, le deuxième point de prélèvement et le n-ième point de prélèvement comprennent des points illogiques qui sont sélectionnés au hasard par la méthode d'échantillonnage aléatoire ; et
le premier nombre de puces LED (301), le deuxième nombre de puces LED (301) et le n-ième nombre de puces LED (301) comprennent de 0 à 8 puces LED (301).

5. Méthode de fabrication de la revendication 1, dans laquelle le lot de puces LED (301) de spécifications identiques ou différentes provient d'un wafer d'une seule spécification ou de wafers d'une pluralité de spécifications ; et les puces LED (301) comprennent une puce Mini LED ou Micro LED à flip-chip.

6. Méthode de fabrication de la revendication 1, dans laquelle la méthode d'échantillonnage aléatoire comprend une méthode de table de nombres aléatoires, dans laquelle une table de nombres aléatoires comprend l'une des tables de nombres aléatoires de Fisher-Yates, une table de nombres aléatoires de Tippet et une table de nombres aléatoires de Kendell-Smith.

7. Méthode de fabrication de la revendication 1, dans laquelle la préparation du lot de puces LED (301) de spécifications identiques ou différentes consiste à placer les puces LED (301) de spécifications identiques provenant de différentes plaquettes de manière séquentielle sur une pluralité de films de support.

8. Méthode de fabrication de la revendication 1, dans lequel le prélèvement des puces LED (301) de façon illogique selon la méthode d'échantillonnage aléatoire, et la disposition des puces LED (301) en séquence comprend la disposition des puces LED (301) sur un substrat en séquence ;
dans lequel l'emballage et l'assemblage des puces LED (301) disposées en séquence pour former l'écran d'affichage LED comprennent :
emballer les puces LED (301) disposées sur le substrat ; et
transférer les puces LED emballées (301) sur un substrat de circuit et les assembler pour former l'écran d'affichage LED ; et
dans lequel le transfert des puces LED emballées (301) sur le substrat du circuit comprend le transfert des puces LED emballées (301) une par une séquentiellement ou le transfert d'une pluralité de puces LED emballées (301) dans un lot.

9. Méthode de fabrication de la revendication 1, dans lequel le prélèvement des puces LED (301) de manière illogique selon uneméthode d'échantillonnage aléatoire et la disposition des puces LED (301) en séquence comprennent en outre une méthode d'échantillonnage aléatoire, et l'agencement des puces LED (301) prélevées en séquence comprend en outre :
prélever les puces LED (301) directement sur une plaquette dont les puces LED (301) sont découpées de manière illogique selon la méthode d'échantillonnage aléatoire ; et
disposer les puces LED sélectionnées (301) sur un film support.

10. Méthode de fabrication de la revendication 9, dans lequel l'emballage et l'assemblage des puces LED (301) disposées en séquence pour former l'écran d'affichage LED comprend :
transférer les puces LED (301) disposées sur le film support sur un substrat de circuit dans un lot ; et
emballer et assembler les puces LED (301) transférées sur le substrat du circuit pour former l'écran d'affichage LED.

11. Méthode de fabrication de la revendication 2, dans laquelle la direction de prélèvement prédéterminée (O1) est formulée pour passer au moins deux bacs adjacents qui ont des spécifications différentes de luminosité et/ou de couleur des puces LED (301).

12. Méthode de fabrication selon la revendication 11, dans laquelle la direction de prélèvement prédéterminée (O1) n'est pas la même que la manière d'agencement prédéterminée (O2).
